# EUROPÄISCHE PATENTSCHRIFT

(11) **EP 3 442 036 B1**
(45) Veröffentlichungstag und Bekanntmachung des Hinweises auf die Patenterteilung: **24.06.2020**
(21) Anmeldenummer: 17185538.0
(22) Anmeldetag: 09.08.2017
(51) Int. Cl.: H01L 31/0725, H01L 31/0745

(54) **OPTOELEKTRONISCHES HALBLEITERBAUELEMENT**
OPTOELECTRONIC SEMICONDUCTOR ELEMENT
COMPOSANT SEMI-CONDUCTEUR OPTOÉLECTRONIQUE

(43) Veröffentlichungstag der Anmeldung: 13.02.2019
(73) Patentinhaber: AE 111 Autarke Energie GmbH, 9556 Liebenfels (AT)
(72) Erfinder: Schüppen, Andreas Paul, 8020 GRAZ (AT)
(74) Vertreter: Epping - Hermann - Fischer

(56) Entgegenhaltungen:
- EP-A2- 0 895 291
- DE-A1-102006 024 850
- DE-B4-102005 047 221
- US-A1- 2014 048 122

## Beschreibung

Es wird ein optoelektronisches Halbleiterbauelement angegeben.

Die Druckschrift US 2014/0048122 A1 betrifft eine Tandemsolarzelle, bei der eine obere Diode auf Silizium basiert und eine SiC-Schicht umfasst. Eine untere Diode umfasst eine Germaniumschicht als Basis für Nanodrähte.

Eine zu lösende Aufgabe liegt darin, ein optoelektronisches Halbleiterbauelement anzugeben, das einen hohen Leistungswirkungsgrad und Energiewirkungsgrad bezüglich der Umwandlung von Lichtleistung und Lichtenergie in elektrische Leistung beziehungsweise Energie aufweist. Das optoelektronische Halbleiterbauelement ist insbesondere eine Solarzelle mit einer offenen Klemmenspannung V_{oc} von über 1 V.

Diese Aufgabe wird unter anderem durch ein optoelektronisches Halbleiterbauelement mit den Merkmalen des unabhängigen Patentanspruchs gelöst. Bevorzugte Weiterbildungen sind Gegenstand der abhängigen Ansprüche.

Erfindungsgemäß weist das optoelektronische Halbleiterbauelement eine Vorderseite auf. Es ist möglich, dass durch die Vorderseite Strahlung wie Sonnenstrahlung in das Halbleiterbauelement eintritt. Die Vorderseite kann eine Strahlungseintrittsseite sein. An der Strahlungseintrittsseite kann sich eine Lichteintrittsschicht, speziell eine Antireflexschicht, befinden.

Erfindungsgemäß umfasst das Halbleiterbauelement eine erste Diode und eine zweite Diode, die in Reihe geschaltet sind. Die Dioden können auch als obere und untere Diode bezeichnet werden. In Richtung weg von der Vorderseite sind die erste und die zweite Diode einander nachgeordnet. Dabei befindet sich die erste Diode näher an der Vorderseite als die zweite Diode. In Draufsicht gesehen können die Vorderseite, die erste Diode und/oder die zweite Diode deckungsgleich angeordnet sein.

Erfindungsgemäß weist das Halbleiterbauelement einen elektrischen Halbleiter-Tunnelkontakt auf. Der Tunnelkontakt befindet sich zwischen der ersten und der zweiten Diode. Über den Tunnelkontakt sind die beiden Dioden elektrisch in Serie geschaltet.

Gemäß zumindest einer Ausführungsform sind die erste Diode und die zweite Diode sowie der Tunnelkontakt monolithisch aufeinander erzeugt. Das heißt, diese Komponenten sind in einem gemeinsamen Halbleiterkörper bevorzugt verbindungsmittelfrei und/oder monolithisch integriert.

Der Tunnelkontakt kann aufgebaut sein, wie in der Druckschrift DE 10 2005 047 221 B4 beschrieben, siehe insbesondere Absatz 9, oder wie in der Druckschrift S. M. Sze, Physics of Semiconductor Devices, New York, Wiley, 1981, Seiten 516ff. Es geht bei dem Tunnelkontakt vor allem um Band zu Band-Tunneln, auch als Intergap tunneling bezeichnet.

Erfindungsgemäß basiert das Halbleiterbauelement auf Silizium. Das heißt, die wesentliche stoffliche Komponente des Halbleiterbauelements ist Si. Ebenso gehen die wesentlichen elektrischen Funktionen des Halbleiterbauelements auf Si zurück. Dies schließt nicht aus, dass eine oder mehrere Dotierungen vorhanden sind oder dass das Si zum Teil durch andere Materialien ersetzt ist, insbesondere durch Gruppe IV-Materialien wie Kohlenstoff und/oder Germanium. Das heißt, bei dem Halbleiterbauelement handelt es sich insbesondere um eine Silizium-basierte Solarzelle.

Erfindungsgemäß umfasst die erste Diode oder obere Diode mehrere Teilschichten. Eine erste und dritte Teilschicht sind aus (Si_{y}Ge_{1-y})₁₋ₓCₓ mit 0,05 ≤ x ≤ 0,5 oder 0,25 ≤ x ≤ 0,75 und mit 0 ≤ y ≤ 1 und eine zweite Teilschicht ist aus Si_{z}Ge_{1-z} ist mit 0 ≤ z ≤ 1, wobei eventuell vorhandene Dotierungen vernachlässigt sind.

Si und Ge können in beliebigen Mischungsverhältnissen vorliegen. Ferner können verschiedene Phasen durchmischt vorliegen, beispielsweise SiC und GeC. Damit kann sich der Ausdruck (Si, Ge)₁₋ₓCₓ auf eine mittlere Zusammensetzung über die betreffende Schicht hinweg beziehen.

Erfindungsgemäß umfasst die zweite oder untere Diode eine Diodenschicht aus SiₙGe₁₋ₙ, insbesondere als Teil eines pn-Übergangs, wobei in die Raumladungszone dieses pn-Übergangs eine Schicht aus SiₙGe₁₋ₙ eingebaut sein kann. Dabei gilt 0 ≤ n ≤ 1 oder 0 ≤ n < 1 oder 0 < n ≤ 1, insbesondere 0 ≤ n ≤ 0,95, bevorzugt 0 ≤ n ≤ 0,8, sodass der Ge-Anteil mindestens 20 % beträgt. Es kann sich um eine reine Ge-Schicht handeln. Wiederum sind eventuell vorhandene Dotierungen vernachlässigt.

Es wird somit ein Silizium basiertes optoelektronisches Halbleiterbauelement aus zwei in Reihe geschalteten Dioden, die durch einen Tunnelkontakt verbunden sind, angegeben.

Mit anderen Worten kann es sich bei dem Halbleiterbauelement um eine Tandem-Solarzelle auf Siliziumbasis handeln, deren beiden Dioden sich dadurch auszeichnen, dass die erste Diode insbesondere in Form der Teilschicht eine ultraviolett absorbierende und die zweite Diode insbesondere in Form der Diodenschicht einen Infrarot-Absorber beinhaltet. Dadurch wird das von dem Halbleiterbauelement nutzbare Spektrum von ungefähr 300 nm bis 1500 nm ausgeweitet. Hierbei ist die Teilschicht der ersten Diode bevorzugt eine Siliziumcarbidschicht und/oder eine Germaniumcarbidschicht und die Diodenschicht der zweiten Diode ist bevorzugt eine Si-Diode und kann durch eine Germaniumschicht oder eine Siliziumgermaniumschicht ergänzt sein.

Die Solarzellen mit dem derzeit höchsten bekannten Wirkungsgraden sind lediglich Labormuster und basieren üblicherweise auf III-V-Halbleitermaterialien. Deren Wirkungsgrad liegt bis zu 45 % bei Labormustern. Kommerzielle Solarzellen dagegen weisen, abhängig vom verwendeten Materialsystem und der Schichtung, Spitzenwirkungsgrade im Bereich bis 25 % auf. Kommerzielle Solarzellen in der Produktion, die auf kristallinem Silizium basieren, weisen derzeit normalerweise einen Wirkungsgrad im Bereich von 17 % bis 23 % auf.

Mit dem hier beschriebenen Halbleiterbauelement wird eine Tandem-Solarzelle auf Siliziumbasis angegeben. Bisher wurde bei Solarzellen auf Siliziumbasis kaum auf das Tandemkonzept zurückgegriffen, da keine Materialien mit unterschiedlichen Bandabständen im Siliziummaterialsystem soweit zur Verfügung stehen, dass sie nicht kosteneffizient herzustellen sind und/oder nur eine unzureichende Langzeitstabilität aufweisen, wie zum Beispiel Pervoskite. Dagegen lässt sich das hier beschriebene Halbleiterbauelement mit erprobten Techniken und Materialien mit bekannten Eigenschaften aufbauen.

Dabei dient die obere Zelle, also die erste Diode, bevorzugt im Wesentlichen zur Ladungsträgererzeugung aus blauem Licht und aus ultravioletter Strahlung und die untere Zelle, also die zweite Diode, insbesondere nur zur Ladungsträgererzeugung aus Licht bei Wellenlängen über zirka 500 nm bis in den infraroten Spektralbereich. Somit wird im Betrieb ein Strom erzeugt, der durch die beiden in Reihe geschalteten Zellen verläuft und der für eine Standard-MO-Zelle bei über 7 A liegen kann. Mittels der Reihenschaltung der Zellen, also der beiden Dioden, addieren sich die offenen Klemmenspannungen der beiden Zellen zu zirka 1 V bis 1,2 V, sodass ein Wirkungsgrad von über 30 % erreichbar ist. Dies bedeutet, dass für eine Standard-Solarzelle mit Abmessungen von 156 mm x 156 mm eine Leistung von 7 W oder mehr realisierbar ist. Heute haben die besten Siliziumzellen bei einer typischen Größe von 156 mm x 156 mm ungefähr maximal 5 W.

Dazu besteht zumindest eine Teilschicht der ersten Diode aus einem Material mit einem hohen Bandabstand, bevorzugt aus Siliziumcarbid und/oder Germaniumcarbid oder aus amorphen Silizium oder amorphen Germanium. Der Bandabstand von diesem Material liegt insbesondere zwischen 2,4 eV und 3,2 eV, um vor allem kurzwellige Photonen im Wellenlängenbereich von 300 nm bis 500 nm in elektrischen Strom umzuwandeln. Die erste Diode kann dadurch verbessert werden, dass die Raumladungszone eine Quantenstruktur aus SiGeC/SiGe/SiGeC umfasst. Eine solche Struktur, auch als Doppeltunnelstruktur bezeichnet, ermöglicht vermehrt Elektroneneffekte, sodass ein hochenergetisches Photon mehrere Elektronen generieren kann.

Eine solche Doppeltunnelstruktur ist beispielsweise der Druckschrift DE 10 2005 047 221 B4 zu entnehmen, siehe insbesondere Absatz 9.

Erfindungsgemäß umfasst die erste Diode eine erste Teilschicht, eine zweite Teilschicht und eine dritte Teilschicht. Insbesondere durch diese drei Teilschichten wird die Doppeltunnelstruktur der ersten Diode gebildet.

Erfindungsgemäß ist die erste Teilschicht aus SiGeC. Gleiches gilt für die dritte Teilschicht. Die erste und die dritte Teilschicht weisen bevorzugt die gleiche Materialzusammensetzung und/oder die gleichen Schichtdicken auf. Alternativ ist es möglich, dass die erste und die dritte Teilschicht voneinander verschiedene Materialzusammensetzungen aufweisen und/oder unterschiedlich dick gestaltet sind.

Erfindungsgemäß ist die zweite Teilschicht, die sich zwischen der ersten und der dritten Teilschicht befindet, aus SiGe. Damit weist die zweite Teilschicht im Vergleich zur ersten und zur dritten Teilschicht eine vergleichsweise geringe Bandlücke auf. Insbesondere ist die zweite Teilschicht aus Si_{z}Ge_{1-z} mit 0,1 ≤ z ≤ 0,95, bevorzugt mit 0,6 ≤ z ≤ 0,9.

Erfindungsgemäß folgen die erste, die zweite und die dritte Teilschicht in der genannten Reihenfolge in Richtung weg von der Vorderseite unmittelbar aufeinander. In Draufsicht gesehen können die Teilschichten deckungsgleich angeordnet sein.

Erfindungsgemäß sind die erste und die dritte Teilschicht aus (Si_{y}Ge_{1-y})₁₋ₓCₓ. Dabei gilt 0,05 ≤ x ≤ 0,5 oder 0,25 ≤ x ≤ 0,75, bevorzugt 0,4 ≤ x ≤ 0,6. Außerdem gilt 0 ≤ y ≤ 1, bevorzugt 0,25 ≤ y ≤ 0,9, besonders bevorzugt 0,4 ≤ x ≤ 0,7.

Gemäß zumindest einer Ausführungsform weisen die erste und/oder die dritte Teilschichten eine Dicke auf, die unterhalb der Tunnelbedingung liegen, also kleiner als 10 nm sind. Alternativ oder zusätzlich liegen die Dicken der ersten und/oder der dritten Teilschichten bei mindestens 1 nm.

Die untere Zelle, also die zweite Diode, ist im Wesentlichen aus Silizium mit einem Bandabstand von ungefähr 1,12 eV gebildet und vor allem zur Ladungsträgererzeugung aus Licht im Spektralbereich zwischen 500 nm und 1150 nm eingerichtet. Durch die Einfügung der Schicht aus SiGe in die Raumladungszone der unteren Diode mit einem Bandabstand im Bereich von 0,66 eV bis 0,95 eV kann der zur Ladungsträgererzeugung nutzbare infrarote Wellenlängenbereich auf über 1500 nm erweitert werden, was einer Stromerhöhung im Vergleich zu reinem Silizium zur Folge hat.

Gemäß zumindest einer Ausführungsform weist die zweite Teilschicht eine Dicke von mindestens 5 nm auf. Alternativ oder zusätzlich liegt die Dicke der zweiten Teilschicht bei höchstens 25 nm, je nach Dicke der ersten und der dritten Teilschicht und der Materialzusammensetzung der zweiten Schicht.

Bevorzugt ist die zweite Teilschicht dicker als die erste und/oder die dritte Teilschicht, beispielsweise um mindestens einen Faktor 2 dicker als die erste und/oder die dritte Teilschicht.

Gemäß zumindest einer Ausführungsform weist die Diodenschicht der zweiten Diode eine Dicke von mindestens 5 nm auf, insbesondere eine Dicke von mindestens 25 nm. Alternativ oder zusätzlich liegt die Dicke der Diodenschicht bei höchstens 200 nm.

Gemäß zumindest einer Ausführungsform befindet sich an einer der Vorderseite abgewandten Seite der Diodenschicht eine zweite Kontaktschicht. Die zweite Kontaktschicht kann sich direkt an der Diodenschicht befinden.

Gemäß zumindest einer Ausführungsform handelt es sich bei der zweiten Kontaktschicht um eine Siliziumschicht. Diese Siliziumschicht ist bevorzugt mit B und/oder Ga und/oder Al dotiert, beispielsweise mit einer Dotierstoffkonzentration von mindestens 1 x 10¹⁹ 1/cm3 für p-Material oder 3 x 10¹⁹ 1/cm³ für n-Material, das heißt, oberhalb der Entartung, das heißt, für p-Material liegt das Fermi-Niveau unterhalb des Valenzbandes und für n-Material liegt das Fermi-Niveau oberhalb des Leitungsbandes.

Gemäß zumindest einer Ausführungsform weist die zweite Kontaktschicht eine Dicke von mindestens 10 nm auf. Alternativ oder zusätzlich liegt die Dicke der zweiten Kontaktschicht bei höchstens 300 nm, abhängig vom Materialsystem, dem Kontaktsystem und der Kristallinität der Kontaktschicht.

Gemäß zumindest einer Ausführungsform befindet sich zwischen der Diodenschicht und der Vorderseite eine Trägerschicht. Die Trägerschicht kann sich direkt an der Diodenschicht befinden. Bevorzugt ist die Trägerschicht aus Silizium, insbesondere aus n-dotiertem oder aus p-dotiertem Silizium. Es ist möglich, dass es sich bei der Trägerschicht um die das Halbleiterelement mechanisch stützende und tragende Komponente handelt. Beispielsweise weist die Trägerschicht eine Dicke von mindestens 30 µm und/oder von höchstens 600 µm auf. Die Trägerschicht kann auch aus einem Silizid oder einem transparenten leitfähigen Oxid oder einem Glas sein.

Gemäß zumindest einer Ausführungsform sind die Teilschichten der ersten Diode und/oder die Diodenschicht der zweiten Diode sowie optional weitere Halbleiterschichten des Halbleiterbauelements einkristallin oder polykristallin gestaltet. Alternativ ist es möglich, dass diese vorgenannten Halbleiterschichten oder zumindest einige dieser Halbleiterschichten amorph sind.

Gemäß zumindest einer Ausführungsform sind die vorgenannten Halbleiterschichten mittels chemischer Gasphasenabscheidung, kurz CVD (Chemical Vapor Deposition), mittels Atomlagenabscheidung, kurz ALD (Atomic Layer Deposition), und/oder mittels Molekularstrahlepitaxie, kurz MBE (Molecular Beam Epitaxy), erzeugt und/oder aufgebracht. Alternativ können auch ähnliche Abscheideverfahren herangezogen werden, wie zum Beispiel Plasma unterstützte Abscheidungen.

Gemäß zumindest einer Ausführungsform handelt es sich bei dem Halbleiterbauelement um eine Tandem-Solarzelle. Dazu ist es möglich, dass das Halbleiterbauelement weitere Komponenten wie Elektroden, Stromverteilungsstrukturen und/oder elektrische Kontaktstellen zur externen elektrischen Kontaktierung umfasst, insbesondere zum Abgreifen des im Betrieb entstehenden Fotostroms.

Nachfolgend wird ein hier beschriebenes optoelektronisches Halbleiterbauelement unter Bezugnahme auf die Zeichnung anhand eines Ausführungsbeispiels näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figuren 1 und 2: schematische Schnittdarstellungen von Ausführungsbeispielen von hier beschriebenen optoelektronischen Halbleiterbauelementen,
- Figur 3: eine schematische Darstellung einer Bandstruktur eines hier beschriebenen optoelektronischen Halbleiterbauelements, und
- Figur 4: eine schematische Darstellung von spektralen Eigenschaften eines hier beschriebenen optoelektronischen Halbleiterbauelements.

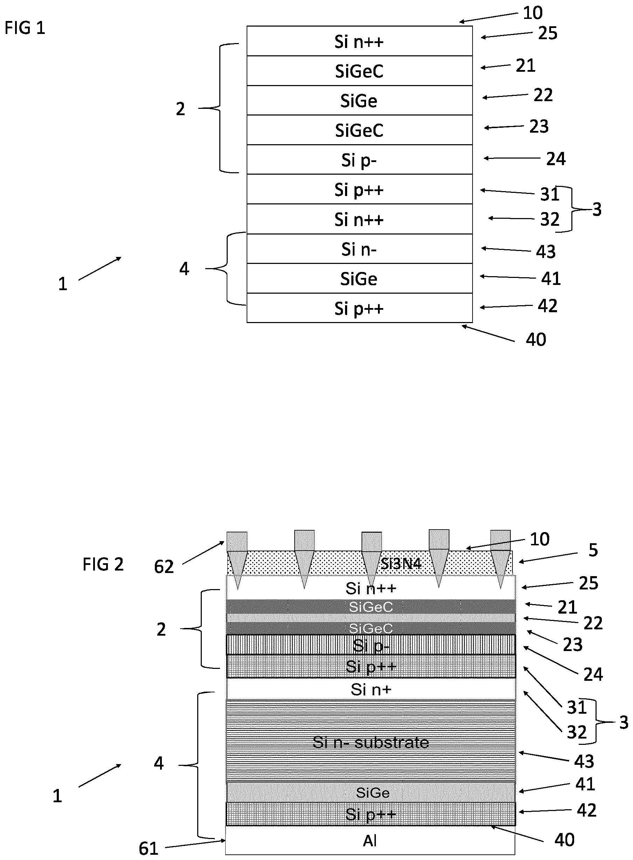

In Figur 1 ist ein Ausführungsbeispiel eines Halbleiterbauelements 1 gezeigt. Das Halbleiterbauelement 1 ist als Tandem-Solarzelle gestaltet und umfasst eine erste Diode 2 und eine zweite Diode 4, die elektrisch über einen Tunnelkontakt 3 miteinander verbunden und in Serie geschaltet sind. Dabei befindet sich die erste Diode 2 näher an einer Vorderseite 10 des Halbleiterbauelements 1, wobei es sich bei der Vorderseite 10 bevorzugt um eine Strahlungseintrittsseite des Halbleiterbauelements 1 handelt.

Als Emitter dient an der Strahlungseintrittsseite 10 eine erste Kontaktschicht 25. Die erste Kontaktschicht 25 ist aus Silizium, das n-hochdotiert beispielsweise mit As ist. Der Dotierungsgrad der Schichten ist durch die Symbole -, +, ++ fachüblich veranschaulicht. Eine Dicke der ersten Kontaktschicht 25 liegt bevorzugt bei mindestens 10 nm und/oder bei höchstens 150 nm, beispielsweise bei 80 nm. Bei der ersten Kontaktschicht 25 kann es sich um eine Doppelschicht mit einer Anfangsdotierung von 1 x 10¹⁸ 1/cm⁻³ und einer hochdotierten Schicht mit einer Dotierstoffkonzentration von 2 x 10²⁰ 1/cm³ handeln. Die Dotierung nimmt bevorzugt hin zur Lichteintrittsschicht 5 zu, das heißt, der Übergang zwischen der ersten und zweiten oberen Kontaktschicht kann auch graduiert ausgeführt sein, das heißt er muss nicht abrupt erfolgen.

Die erste Kontaktschicht 25 ist zum Teil von der ersten Diode 2 umfasst. Eine Hauptkomponente der ersten Diode 2 ist durch drei Teilschichten 21, 22, 23 gebildet. Die erste und die dritte Teilschicht 21, 23 sind SiGeC-Schichten, zwischen denen sich eine bevorzugt dünne SiGe-Schicht als zweite Teilschicht 22 befindet. Die Teilschichten 21, 22, 23 sind im Wesentlichen zur Absorption von kurzwelligem Licht im Bereich von 300 nm bis ca. 500 nm eingerichtet und dient zur Erzeugung von Strom mittels Strahlung aus diesem Wellenlängenbereich.

In Richtung weg von der Strahlungseintrittsseite 10 folgt den Teilschichten 21, 22, 23 eine niedrig p-dotierte Schicht 24 nach. Bei der niedrig dotierten Schicht 24 handelt es sich bevorzugt um eine Siliziumschicht, die mit B dotiert ist. Eine Dicke der niedrig dotierten Schicht 24 liegt beispielsweise bei mindestens 30 nm oder 50 nm und/der bei höchstens 200 nm oder 100 nm.

Der darauffolgende Tunnelkontakt 3 ist aus einer ersten Tunnelkontaktschicht 31 und einer zweiten Tunnelkontaktschicht 32 zusammengesetzt. Die sich näher an der Strahlungseintrittsseite 10 befindliche erste Tunnelkontaktschicht 31 ist bevorzugt eine bis zur Entartung p-dotierte Siliziumschicht, also zum Beispiel über 8 x 10¹⁸ 1/cm³ Bor dotiert. Bei der zweiten Tunnelkontaktschicht 32 handelt es sich bevorzugt um eine bis zur Entartung n-dotierte Siliziumschicht, wobei als Dotierstoff beispielsweise P oder As verwendet wird und die Dotierung oberhalb von 2 x 10¹⁹ 1/cm³ betragen sollte. Dicken der Tunnelkontaktschichten 31, 32 liegen bevorzugt je bei mindestens 20 nm oder 40 nm und/oder bei höchstens 150 nm oder 80 nm, insbesondere je bei zirka 50 nm.

Der Tunnelkontakt 3 befindet sich direkt an einer Trägerschicht 43. Die Trägerschicht 43 ist durch ein n-dotiertes oder alternativ auch p-dotiertes Siliziumsubstrat gebildet. Eine Leitfähigkeit der Trägerschicht 43 liegt bevorzugt bei mindestens 1 Ωcm und/oder bei höchstens 6 Ωcm. Eine Dicke der Trägerschicht 43 beträgt bevorzugt ungefähr 180 µm.

Direkt an der Trägerschicht 43, die einen Teil der zweiten Diode 4 bildet, befindet sich eine Diodenschicht 41, bevorzugt aus SiGe. Die Diodenschicht 41 ist undotiert oder leicht p-dotiert. Beispielsweise weist die Diodenschicht 41 eine Dicke von 50 nm auf.

Der Diodenschicht 41 folgt weg von der Strahlungseintrittsseite 10 eine zweite Kontaktschicht 42 nach, bei der es sich um eine hochdotierte p-Schicht handelt. Als Dotierstoff wird beispielsweise B oder Ga oder Al verwendet. Eine Dicke der zweiten Kontaktschicht 42 liegt beispielsweise bei 100 nm.

Beim Ausführungsbeispiel der Figur 2 ist die Strahlungseintrittsseite 10 durch eine Lichteintrittsschicht 5 gebildet, insbesondere aus einem Nitrid wie Siliziumnitrid oder einem transparenten leitfähigen Oxid, kurz TCO. Eine Dicke der Lichteintrittsschicht liegt beispielsweise bei mindestens 50 nm und/oder 90 nm, insbesondere bei zirka 65 nm.

An der Strahlungseintrittsseite 10 ist zur elektrischen Kontaktierung eine Kontaktschicht 62 etwa mittels Silber-Siebdruck aufgebracht. Hierzu wird die optionale Lichteintrittsschicht 5 bevorzugt stellenweise insbesondere selbstjustierend durch ein bekanntes Verfahren entfernt.

An einer der Strahlungseintrittsseite 10 gegenüberliegenden Rückseite 40, also an der zweiten Kontaktschicht 42, wird bevorzugt etwa mittels Aluminium-Siebdruck eine weitere Elektrode 61 flächig oder strukturiert aufgebracht. Anschließend kann ein Feuerungsprozess erfolgen. Somit ist das als Solarzelle gestaltete Halbleiterbauelement 1 mit Standardverfahren herstellbar.

Im Übrigen entspricht das Ausführungsbeispiel der Figur 2 dem der Figur 1.

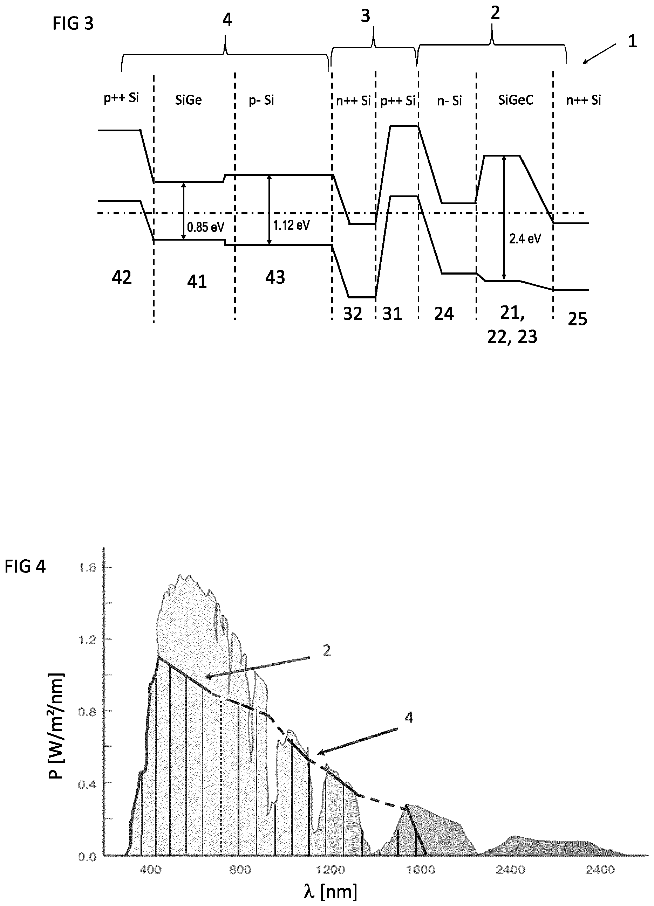

Die sich aus diesem in Verbindung mit den Figuren 1 und 2 erläuterten Aufbau ergebende elektronische Bandstruktur ist in Figur 3 schematisch illustriert. Für Teilabschnitte ist die jeweilige Bandlücke in eV angegeben. Durch die Strich-Linien sind die Grenzen zwischen den Schichten des Halbleiterbauelements 1 symbolisiert. Als Strich-Punkt-Linie ist die Null-Linie hinsichtlich der Bandlücke veranschaulicht. Abweichend von den Figuren 1 oder 2 können gemäß Figur 3 auch andere Dotierungen etwa in den Schichten 24, 43 vorliegen.

In Figur 4 ist die Licht-Einstrahlungsleistung P für Sonnenlicht in W/m²/nm gegenüber der Wellenlänge λ in nm dargestellt. Die Absorptionsbereiche für die erste Diode 2 und die zweite Diode 4 sind schematisch eingezeichnet.

Die in den Figuren gezeigten Komponenten folgen, sofern nicht anders kenntlich gemacht, bevorzugt in der angegebenen Reihenfolge jeweils unmittelbar aufeinander. Ebenfalls, soweit nicht anders kenntlich gemacht, sind die relativen Positionen der gezeichneten Komponenten zueinander in den Figuren korrekt wiedergegeben.

## Patentansprüche

1. Auf Silizium basierendes optoelektronisches Halbleiterbauelement (1) mit
- einer Vorderseite (10),
- einer ersten Diode (2) und einer zweiten Diode (4), die in Richtung weg von der Vorderseite (10) einander nachgeordnet und elektrisch in Reihe geschaltet sind, sodass sich die erste Diode (2) näher an der Vorderseite (10) befindet als die zweite Diode (4), und
- einem elektrischen Tunnelkontakt (3) zwischen der ersten und der zweiten Diode (2, 4),
wobei die zweite Diode (4) eine Diodenschicht (41) aus SiₙGe₁-ₙ umfasst mit 0 ≤ n ≤ 1,
**dadurch gekennzeichnet, dass**
die erste Diode (2) eine erste Teilschicht (21) aus SiGeC, eine zweite Teilschicht (22) aus SiGe und eine dritte Teilschicht (23) aus SiGeC umfasst und die Teilschichten (21, 22, 23) entsprechend ihrer Nummerierung in Richtung weg von der Vorderseite (10) unmittelbar aufeinander folgen, sodass die erste und dritte Teilschicht (21, 23) aus (Si_{y}Ge_{1-y})₁₋ₓCₓ sind mit 0,05 ≤ x ≤ 0,5 oder 0,25 ≤ x ≤ 0,75 und mit 0 ≤ y ≤ 1 und die zweite Teilschicht (22) aus Si_{z}Ge_{1-z} ist mit 0 ≤ z ≤ 1.

2. Optoelektronisches Halbleiterbauelement (1) nach dem vorhergehenden Anspruch,
bei dem die erste Diode (2) zur Absorption von Strahlung im Wellenlängenbereich zwischen 300 nm und 500 nm und zur Erzeugung von Ladungsträgern mittels dieser Strahlung eingerichtet ist.

3. Optoelektronisches Halbleiterbauelement (1) nach einem der vorhergehenden Ansprüche,
bei dem die zweite Diode (2) zur Absorption von Strahlung im Wellenlängenbereich zwischen 500 nm und 1500 nm und zur Erzeugung von Ladungsträgern mittels dieser Strahlung eingerichtet ist.

4. Optoelektronisches Halbleiterbauelement (1) nach einem der vorhergehenden Ansprüche,
bei dem die erste und die dritte Teilschicht (21, 23) die gleiche Materialzusammensetzung aufweisen mit 0,4 ≤ x ≤ 0,6 und mit 0,25 ≤ y ≤ 0,9.

5. Optoelektronisches Halbleiterbauelement (1) nach einem der vorhergehenden Ansprüche,
bei dem die erste und die dritte Teilschicht (21, 23) jeweils eine Dicke zwischen einschließlich 1 nm und 10 nm aufweisen und eine Dicke der zweiten Teilschicht (22) zwischen einschließlich 5 nm und 25 nm liegt.

6. Optoelektronisches Halbleiterbauelement (1) nach einem der vorhergehenden Ansprüche,
bei dem für die zweite Teilschicht gilt: 0,1 ≤ z ≤ 0,95.

7. Optoelektronisches Halbleiterbauelement (1) nach einem der vorhergehenden Ansprüche,
bei dem für die Diodenschicht (41) aus SiₙGe₁-ₙ gilt: 0 ≤ n ≤ 0,8,
wobei die Diodenschicht (41) eine Dicke zwischen einschließlich 5 nm und 200 nm aufweist.

8. Optoelektronisches Halbleiterbauelement (1) nach einem der vorhergehenden Ansprüche,
bei dem
- sich direkt an einer der Vorderseite (10) abgewandten Seite der Diodenschicht (41) eine zweite Kontaktschicht (42) befindet, die eine Si-Schicht mit einer Dotierung mit B, Al und/oder Ga mit einer Dotierstoffkonzentration von mindestens 1 x 10¹⁹ 1/cm3 und mit einer Dicke zwischen einschließlich 30 nm und 300 nm ist, und
- die Diodenschicht (41) in Richtung hin zur Strahlungseintrittsseite (10) unmittelbar an eine Trägerschicht (43) aus dotiertem Si mit einer Dicke zwischen einschließlich 30 µm und 600 µm grenzt.

9. Optoelektronisches Halbleiterbauelement (1) nach einem der vorhergehenden Ansprüche,
bei dem die Halbleiterschichten der ersten und/oder der zweiten Diode (2, 4) einkristallin, polykristallin oder amorph sind.

10. Optoelektronisches Halbleiterbauelement (1) nach einem der vorhergehenden Ansprüche,
das eine Tandem-Solarzelle ist.

## Claims

1. An optoelectronic semiconductor component (1) based on silicon comprising:
- a front side (10),
- a first diode (2) and a second diode (4), which are arranged downstream of one another in the direction away from the front side (10) and which are electrically connected in series, such that the first diode (2) is located closer to the front side (10) than the second diode (4), and
- an electrical tunnel contact (3) between the first and the second diode (2, 4),
wherein the second diode (4) comprises a diode layer (41) of SiₙGe₁₋ₙ, where 0 ≤ n ≤ 1,
**characterized in that**
the first diode (2) comprises a first partial layer (21) of SiGeC, a second partial layer (22) of SiGe and a third partial layer (23) of SiGeC, and said partial layers (21, 22, 23) follow one another directly in the direction away from the front side (10) according to their numbering, such that the first and third partial layers (21, 23) are of (Si_{y}Ge_{1-y})₁₋ₓCₓ, whereas 0.05 ≤ x ≤ 0.5 or 0.25 ≤ x ≤ 0.75, and whereas 0 ≤ y ≤ 1, and the second partial layer (22) is of Si_{z}Ge_{1-z}, whereas 0 ≤ z ≤ 1.

2. The optoelectronic semiconductor component (1) according to the preceding claim,
wherein the first diode (2) is configured to absorb radiation in a first wavelength range between 300 nm and 500 nm and is configured to generate charge carriers by means of said radiation.

3. The optoelectronic semiconductor component (1) according to anyone of the preceding claims,
wherein the second diode (2) is configured to absorb radiation in a second wavelength range between 500 nm and 1500 nm and is configured to generate charge carriers by means of said radiation.

4. The optoelectronic semiconductor component (1) according to anyone of the preceding claims,
wherein the first and the third partial layers (21, 23) have the same material composition, where 0.4 ≤ x ≤ 0.6 and 0.25 ≤ y ≤ 0.9.

5. The optoelectronic semiconductor component (1) according to anyone of the preceding claims,
wherein the first and the third partial layers (21, 23) each have a thickness of between 1 nm and 10 nm inclusive, and a thickness of the second partial layer (22) is between 5 nm and 25 nm inclusive.

6. The optoelectronic semiconductor component (1) according to anyone of the preceding claims,
wherein for the second partial layer (22) 0,1 ≤ z ≤ 0,95 applies.

7. The optoelectronic semiconductor component (1) according to anyone of the preceding claims,
wherein the following applies to the diode layer (41) of SiₙGe₁₋ₙ: 0 ≤ n ≤ 0.8,
wherein the diode layer (41) has a thickness of between 5 nm and 200 nm inclusive.

8. The optoelectronic semiconductor component (1) according to anyone of the preceding claims,
wherein
- a second contact layer (42) is located directly on a side of the diode layer (41) facing away from the front side (10), said second contact layer (42) being a Si layer comprising a doping of B, Al and/or Ga with a dopant concentration of at least 1 x 10¹⁹ 1/cm3 and with a thickness between 30 nm and 300 nm inclusive, and
- the diode layer (41) directly adjoins a carrier layer (43) of doped Si with a thickness of between 30 µm and 600 µm inclusive in the direction towards the radiation entry side (10) .

9. The optoelectronic semiconductor component (1) according to anyone of the preceding claims,
wherein the semiconductor layers of the first and/or the second diode (2, 4) are monocrystalline, polycrystalline or amorphous.

10. The optoelectronic semiconductor component (1) according to anyone of the preceding claims,
which is a tandem solar cell.

## Revendications

1. Composant semiconducteur optoélectronique (1) à base de silicium comprenant
- un côté avant (10),
- une première diode (2) et une deuxième diode (4) qui sont disposées l'une derrière l'autre en direction d'éloignement du côté avant (10) et sont connectées électriquement en série de sorte que la première diode (2) soit plus proche du côté avant (10) que la deuxième diode (4), et
- un contact électrique en tunnel (3) entre la première et la deuxième diode (2, 4),
sachant que la deuxième diode (4) comprend une couche de diode (41) en SiₙGe₁₋ₙ avec 0 ≤ n ≤ 1,
**caractérisé en ce que**
la première diode (2) comprend une première couche partielle (21) en SiGeC, une deuxième couche partielle (22) en SiGe et une troisième couche partielle (23) en SiGeC et les couches partielles (21, 22, 23) se succèdent directement conformément à leur numérotation en direction d'éloignement du côté avant (10) de sorte que la première et la troisième couche partielle (21, 23) soient en (Si_{y}Ge_{1-y}) ₁₋ₓCₓ avec 0,05 ≤ x ≤ 0,5 ou 0,25 ≤ x ≤ 0,75 et avec 0 ≤ y ≤ 1 et la deuxième couche partielle (22) soit en Si_{z}Ge_{1-z} avec 0 ≤ z ≤ 1.

2. Composant semiconducteur optoélectronique (1) selon la revendication précédente,
dans lequel la première diode (2) est configurée pour absorber du rayonnement dans la plage de longueur d'onde entre 300 nm et 500 nm et pour générer des supports de charge moyennant ce rayonnement.

3. Composant semiconducteur optoélectronique (1) selon l'une des revendications précédentes,
dans lequel la deuxième diode (2) est configurée pour absorber du rayonnement dans la plage de longueur d'onde entre 500 nm et 1500 nm et pour générer des supports de charge moyennant ce rayonnement.

4. Composant semiconducteur optoélectronique (1) selon l'une des revendications précédentes,
dans lequel la première et la troisième couche partielle (21, 23) présentent la même composition de matière avec 0,4 ≤ x ≤ 0,6 et avec 0,25 ≤ y ≤ 0,9.

5. Composant semiconducteur optoélectronique (1) selon l'une des revendications précédentes,
dans lequel la première et la troisième couche partielle (21, 23) présentent respectivement une épaisseur entre 1 nm et 10 nm inclus et une épaisseur de la deuxième couche partielle (22) est comprise entre 5 nm et 25 nm inclus.

6. Composant semiconducteur optoélectronique (1) selon l'une des revendications précédentes,
dans lequel pour la deuxième couche partielle on a : 0,1 ≤ z ≤ 0,95.

7. Composant semiconducteur optoélectronique (1) selon l'une des revendications précédentes,
dans lequel pour la couche de diode (41) en SiₙGe₁₋ₙ on a :
0 ≤ n ≤ 0,8,
sachant que la couche de diode (41) présente une épaisseur entre 5 nm et 200 nm inclus.

8. Composant semiconducteur optoélectronique (1) selon l'une des revendications précédentes,
dans lequel
- une deuxième couche de contact (42) qui est une couche de Si avec un dopage en B, Al et/ou Ga avec une concentration de dopant d'au moins 1 x 10¹⁹ 1/cm3 et d'une épaisseur entre 30 nm et 300 nm inclus se trouve directement d'un côté de la couche de diode (41) opposé au côté avant (10), et
- la couche de diode (41) jouxte directement une couche de support (43) en Si dopé d'une épaisseur entre 30 µm et 600 µm inclus en direction vers le côté d'entrée de rayonnement (10).

9. Composant semiconducteur optoélectronique (1) selon l'une des revendications précédentes,
dans lequel les couches de semiconducteur de la première et/ou de la deuxième diode (2, 4) sont monocristallines, polycristallines ou amorphes.

10. Composant semiconducteur optoélectronique (1) selon l'une des revendications précédentes,
lequel est une cellule solaire tandem.
